# EUROPEAN PATENT SPECIFICATION

(11) **EP 0 455 518 B1**
(45) Date of publication and mention of the grant of the patent: **31.01.1996**
(21) Application number: 91304102.6
(22) Date of filing: 07.05.1991
(51) Int. Cl.: G01R 11/24

(54) **Electricity meter tamper monitoring**
Ueberwachung unbefugten Gebrauchs eines Elektrizitätszählers
Surveillance de l'emploi abusif d'un compteur d'électricité

(30) Priority: 04.05.1990 GB 9010091
(43) Date of publication of application: 06.11.1991
(73) Proprietor: POLYMETERS RESPONSE INTERNATIONAL LIMITED, Winchester, Hampshire SO23 7RX (GB)
(72) Inventor: Singhal, Sanjaya, Hampshire, SO22 5EX (GB); Yadav, Krishna Kumar, Udaipur 313001 (IN)
(74) Representative: Crawford, Andrew Birkby

(56) References cited:
- EP-A- 0 085 769
- EP-A- 0 107 996
- EP-A- 0 163 440
- US-A- 4 383 210

## Description

This invention relates to meters which measure electrical power and energy consumption and in particular to automatically monitoring tampering with such meters.

It is known to provide a meter which uses solid state electronics to measure the electrical power and energy consumption from a mains electricity supply by, for instance, a domestic or industrial installation. Such a meter typically samples the voltage and current present in the supply and calculates from the values of these samples such quantities as the amount of energy supplied to an installation or real power, true power and volt-ampere power consumed by the load. Meters may be provided to monitor a single phase supply or a 3-phase supply, the latter being either 3-wire or 4-wire.

Inputs may be provided to such meters representative of the current and voltage present in the supply or in each phase of the supply. To provide these inputs potential transformers may be used to provide a voltage proportional to the voltage in the supply and current transformers may be used to provide a voltage proportional to the current in the supply. These transformers would generally be in the form of probes connected to the supply lines, and connected via wires to the inputs of the meter. It is also possible to use only current transformers, and not potential transformers.

In either of the above cases, there are separate wires connected to the meter which carry signals representative of the voltage and currents present in the supply. A common form of tampering with the meter in order to reduce the amount of energy registered as having been used and hence the cost payable by a consumer is to cut or otherwise isolate one or more of the potential wires to the meter. This causes a low or zero potential input to the meter.

In a 3-phase 4-wire system, assuming approximately equal loading on each of the phases, isolating one of the potential wires will cause the energy used in one of the phases not to be measured and hence reduce the measurement of energy used by one third. In practical terms, it is simpler to isolate the wires carrying the potential signal than the wires carrying the current signal.

The wire may be isolated for a given period of time, sometimes up to a week, and then re-installed before the meter is inspected, as the tamper is quite obvious. Because of this, detection of the fraud by an inspector is difficult.

The absence of a potential signal at a meter may also be due to reasons other than tampering which have no connection with the consumer whatsoever. Such an absence may be due to an electrical fault in the supply, a blown fuse, or to loosening of internal connectors due to vibrations.

EP-A-0085769 discloses an electricity meter for metering the amount of electrical energy supplied by a power supplier to a power consumer which is provided with fraud detection means for detecting the presence of an external shunt (76) which has been connected to bypass its internal current sensing means (22). The detecting means comprises a step-up auto transformer (70) having its primary winding (72) connected to receive the supply voltage and is secondary winding (74) connected in series with the current sensing means (22) of the meter.

Whatever the reason, the electricity supply authority may lose revenue due to the reduced registration of the energy consumption.

Thus the present invention provides an apparatus for monitoring an electricity supply to a load comprising:
first sensing means for sensing the supply voltage and generating a first signal indicative of the sensed voltage;
second sensing means for sensing the load current or power consumption by the load corresponding to the supply voltage and generating a second signal indicative of the sensed current or power consumption; and
means which indicates that tampering has occurred in the apparatus,
characterized in that said means is arranged to have inputs thereto said first and second signals as first and second input respectively and indicates that tampering has occurred in the apparatus when the second input indicates the presence of load current or power consumption while the first input indicates the lack of a corresponding supply voltage.

The invention further provides a method for detecting tampering in apparatus for monitoring an electricity supply to a load comprising;
sensing the supply voltage and generating a first signal indicative of the sensed voltage;
sensing the load current or power consumption by the load corresponding to the supply voltage and generating a second signal indicative of the second current or power consumption; and indicating that tampering has occurred in the apparatus, characterized in that said method comprises monitoring said first and second signals and indicating that tampering has occurred when the second signal indicates the presence of load current or power consumption while the first signal indicates the lack of a corresponding supply voltage.

Preferably the invention stores information concerning the tampering, for instance the dates and times at which tampering occurred. The invention is equally applicable to single and poly-phase supplies and preferably in the poly-phase case stores information concerning which phases are tampered with.

A further preferred feature of the poly-phase application is the estimation of the amount of energy used but not measured due to the tampering.

An embodiment of the invention will be described by way of example with reference to the accompanying drawings, in which
Figure 1 is a diagram of an electricity supply meter according to an embodiment of the invention;
Figure 2 is a flow-diagram to illustrate the function of part of the preferred embodiment of this invention; and
Figure 3 is a flow diagram to illustrate the operation of a further embodiment of this invention.

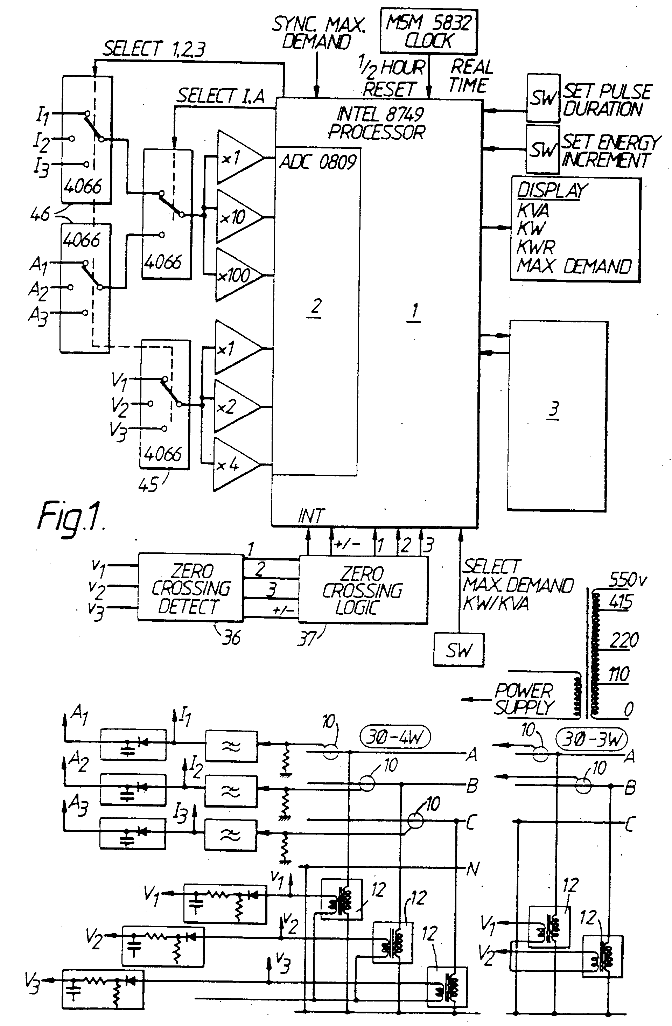

Figure 1 shows a particular embodiment of the present invention. In the embodiment shown in figure 1 signals representative of the current and potential in each phase are derived by way of current transformers 10 and voltage transforms 12. It may be seen that in the 3-phase, 4-wire system 3 of each type of transformer is used, while in the 3-phase, 3-wire system only 2 of each type are used. The operation will be described in relation to the 3-phase, 4-wire system.

The voltage transformers 12 provide signals v₁, v₂, v₃ which are proportional to the actual voltage in the three phases respectively. These therefore vary approximately sinusoidally. There are also provided rectified voltage signals v₁, V₂, V₃ which are proportional to the R.M.S. values of the voltage in each phase respectively.

The current transformers 10 provide signals I₁, I₂, I₃ which produce voltages proportional to the current flowing in each phase. There are also provided signals A₁, A₂, A₃ which are proportional to the maximum current in each phase respectively.

The functions of the electricity meter are under the control of microprocessor 1 and the detailed standard metering operation of the circuit in Figure 1 is described in EP-A-0181719. In general terms, the microprocessor takes as inputs the signals described above. I₁, I₂, I₃; A₁ , A₂, A₃ and V₁ , V₂, V₃ may be input via various gain amplifiers to allow measurement in various ranges. These analog inputs are converted to digital signals in analog-to-digital converter 2. The digital inputs are sampled and the meter performs appropriate calculations to measure such quantities as real power, reactive power and maximum demand on the supply. The meter measures the electricity used in each phase by switching successively between the phases and sampling the inputs.

The electricity meter according to this invention, as well as performing the standard metering function, is also able to identify tampering with the voltage signal lines which tampering is done in an effort to reduce the amount of energy registered as having been used.

An electricity meter according to this particular embodiment of this invention is able to:
i) identify the kind of tamper described above, i.e. the isolation of one or more of the voltage input lines V₁, V₂, V₃ to the microprocessor;
ii) estimate the amount of energy which is used but not directly measured due to the tamper; and
iii) provide to an inspector or user, possibly at a later time, information concerning the time and duration of the tampering.

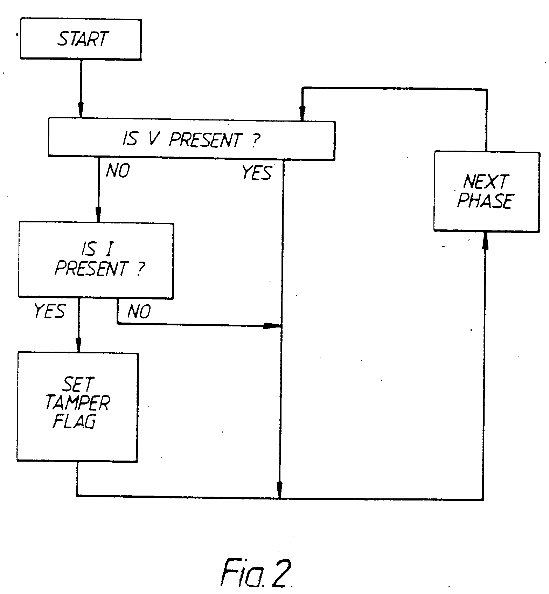

The function of identifying is illustrated by the flow-chart in Figure 2.

In order to identify tampering the microprocessor 1 monitors the input voltage lines V₁, V₂, V₃ and in particular whether there is a voltage present on each phase and registers when a voltage is absent. The presence or absence of a voltage may be decided on an absolute basis, i.e. the voltage must fall to zero in order to be registered as absent, or there may be pre-determined threshold and a voltage is registered as absent on falling below this level.

If a voltage is registered as absent in a particular phase, the microprocessor monitors whether there is current present in that phase. If there is found to be current present in the phase in which the voltage is absent a tamper flag is set in memory 3 to indicate that there is a tamper in that phase. The microprocessor then moves on to monitor the voltage in the next phase.

Thus, when the meter is next inspected, the tampering is noted, preferably together with the date and time at which the tampering began, and the tamper flag is reset manually.

According to another embodiment, the tamper flag in memory 3 is further reset if it is found that there is neither voltage nor current present in a particular phase, and this indicates that tampering is no longer occurring. The flag may be reset in this case because the situation in which there is neither voltage nor current present in a phase is likely to be caused by a fault in the supply rather than by tampering. This is due to the fact that in practical terms, it is far simpler to isolate a voltage input line than a current input line. The tamper flag is also reset if the voltage is found to be present in a particular phase.

Preferably the microprocessor also includes means for entering information in memory 3 to indicate at what times the tamper flags for the various phases are set and reset to indicate the start and finish of tampering with the meter. This information may be read by a remote reading device or at a later stage during inspection cf the meter and/or may be displayed on the meter itself. Alternatively, the memory may only store information indicating the start of the first tamper and the end of the last prior to inspection.

Thus, in summary, a tamper is registered as occurring if voltage is absent but current is present in a particular phase.

If both voltage and current are sensed as absent in the same phase, this is not registered as a tamper, but it may nevertheless be registered as having occurred for the purposes of fault checking at a later stage.

Preferably the microprocessor is also able to estimate the amount of energy used but not registered due to tampering.

Obviously it is not possible to achieve complete accuracy in estimating the amount of energy used but not registered, but is is possible to make a reasonable estimate in either of the following two ways.

The first method utilises simply the energy measured as being used in the phase or phases that have not been tampered with. If the potential in one phase is absent, the energy registered is increased by 50% to estimate the total used and this assumes that the energy used in that missing phase is the average of the energy used in the remaining phases. If the potential in two phases is absent, the energy registered is trebled to estimate the total used, and this assumes that the energy used in each phase is equal.

The second method gives a more accurate estimate of the energy used but not registered. This method uses the currents actually flowing in the phases and uses an average value of the available voltages as an estimate of the voltage in the tampered phase or phases. Thus if the potential in one phase is absent, this potential is estimated as the average of the potentials in the other two phases, and this estimate is used together with the actual current to estimate the energy used. If the potential in two phases is absent, the potential in these phases is estimated as being the same as that in the other phase, and these estimates are used together with the actual currents to estimate the energy used.

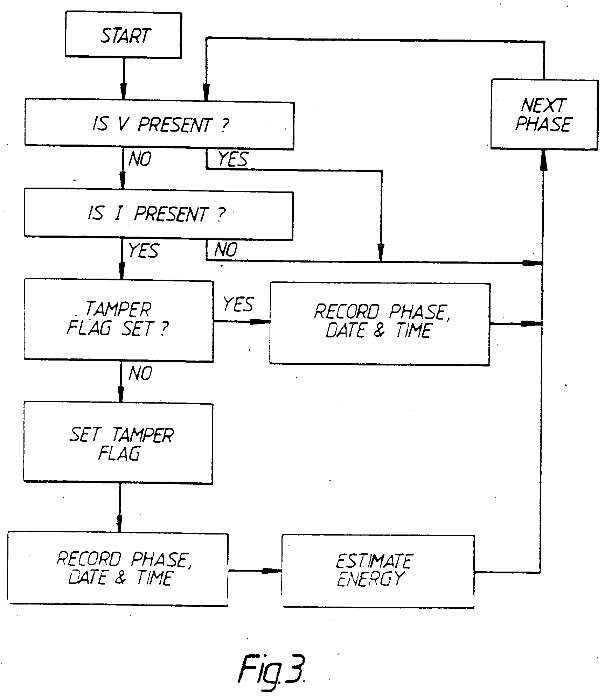

Figure 3 illustrates the operation of an embodiment of the invention which estimate in the presence of the tamper flag the energy which is used but is not measured directly. As can be seen from figure 3, when the tamper flag is set for the first time, the meter begins to estimate the energy which is being used but not measured, and this estimation, by either of the above described methods, continues until the meter is reset at a subsequent inspection.

While the use of separate current and voltage transformers has been described in the particular embodiment above, the use of these not essential. What is essential is that the meter is supplied with signals representative of the supply voltage and/or current and/or power consumption.

Thus the transformers may be replaced, particularly with supplies at a lower capacities, by other arrangements such as current sensing resistor which serves current directly or other suitable known arrangement, and voltage may be determined by resistive voltage divisions.

It is also possible to measure the power consumption directly, e.g. by way of Hall effect device provided that the voltage remains within a nominal range. If this is done, then there is no need to provide a separate current sensing device.

## Claims

1. Apparatus for monitoring an electricity supply to a load comprising:
first sensing means (12) for sensing the supply voltage and generating a first signal indicative of the sensed voltage;
second sensing means (10) for sensing the load current or power consumption by the load corresponding to the supply voltage and generating a second signal indicative of the sensed current or power consumption; and
means (1,3) which indicates that tampering has occurred in the apparatus,
characterized in that said means (1,3) is arranged to have input thereto said first and second signals as first and second inputs respectively and indicates that tampering has occurred in the apparatus when the second input indicates the presence of load current or power consumption while the first input indicates the lack of a corresponding supply voltage.

2. Apparatus as claimed in Claim 1 wherein the first input is taken to indicate the lack of a corresponding voltage if it indicates that the voltage falls to zero.

3. Apparatus as claimed in Claim 1 wherein the first input is taken to indicate the lack of a corresponding voltage if it indicates that the voltage falls below a pre-determined threshold.

4. Apparatus as claimed in Claim 1, 2 or 3 further comprising means which sets a tamper flag in a memory means (3) when tampering is indicated.

5. Apparatus as claimed in Claim 4 wherein the indication of tampering must be present for at least a pre-determined time in order for the tamper flag to be set.

6. Apparatus as claimed in Claim 4 or 5 and further comprising means for storing in the memory means (3) information concerning the date and time of tampering.

7. Apparatus as claimed in any preceding claim for monitoring a poly-phase electricity supply and comprising said first and second means (10,12) for each of a plurality of phases and means to indicate tampering in any of the supply phases.

8. Apparatus as claimed in Claim 7 and comprising means for recording in which phase or phases tampering has occurred.

9. Apparatus as claimed in Claim 7 or 8 and further comprising means responsive to said first and second signals to calculate energy consumed by the load from the supply.

10. Apparatus as claimed in claim 9 and further comprising means for estimating the amount of energy used but not measured due to tampering.

11. Apparatus as claimed in claim 10 wherein the energy estimated assumes that the amount of energy used in each phase in which tampering is indicated is the same as he average of the energy used in the phase or phases in which no tampering is indicated.

12. Apparatus as claimed in claim 11 which is suitable or use in poly-phase circuits using the same number of wires as there are phases and wherein the energy is estimated using the actual current flowing in each phase in which tampering is indicated and correcting for phase shift by means of a look-up table.

13. Apparatus as claimed in claim 10 wherein the energy is estimated assuming that the voltage present in each phase in which tampering is indicated is the same as the average voltage in the phase or phases in which no tampering is indicated and using the actual current flowing in each phase in which tampering is indicated.

14. A method for detecting tampering in apparatus for monitoring an electricity supply to a load comprising;
sensing the supply voltage and generating a first signal indicative of the sensed voltage;
sensing the load current or power consumption by the load corresponding to the supply voltage and generating a second signal indicative of the second current or power consumption; and
indicating that tampering has occurred in the apparatus,
characterized in that said method comprises monitoring said first and second signals and indicating that tampering has occurred when the second signal indicates the presence of load current or power consumption while the first signal indicates the lack of a corresponding supply voltage.

15. A method as claimed in Claim 14 wherein the first signal is taken to indicate the lack of a corresponding voltage if it indicates that the voltage falls to zero.

16. A method as claimed in Claim 14 wherein the first signal is taken to indicate the lack of a corresponding voltage if it indicates that the voltage falls below a pre-determined threshold.

17. A method as claimed in Claim 14, 15 or 16 further comprising setting a tamper flag in a memory means (3) when tampering is indicated.

18. A method as claimed in claim 17 wherein the indication of tampering must be present for at least a pre-determined time in order for the tamper flag to be set.

19. A method as claimed in claim 17 or 18 further comprising storing in the memory means information concerning the date and time of tampering.

20. A method as claimed in any of claims 14-19 for detecting tampering in an apparatus for monitoring a poly-phase electricity supply to a load the method comprising indicating tampering in any of the supply phases.

21. A method as claimed in claim 20 and comprising recording in which phase or phases tampering has occurred.

22. A method as claimed in Claim 20 or 21 and further comprising calculating energy consumed by the load from the supply as a function of said first and second signals.

23. A method as claimed in claim 22 and further comprising estimating the amount of energy used but not measured due to tampering.

24. A method as claimed in claim 23 wherein the energy is estimated assuming that the amount of energy used in each phase in which tampering is indicated is the same as the average of the energy used in the phase or phases in which tampering is not indicated.

25. A method as claimed in claim 24 wherein the energy is estimated using the actual current flowing in each phase in which tampering is indicated and further comprising correcting for phase shift by means of a look-up table.

26. A method as claimed in claim 23 wherein the energy is estimated assuming that the voltage present in each phase in which tampering is indicated is the same as the average voltage in the phase or phases in which tampering is not indicated and using the actual current in each phase in which tampering is indicated.

## Patentansprüche

1. Vorrichtung zum Überwachen einer Elektrizitätsversorgung einer Last, die umfaßt:
eine erste Erfassungseinrichtung (12), die die Speisespannung erfaßt und ein erstes Signal erzeugt, das die erfaßte Spannung anzeigt;
eine zweite Erfassungseinrichtung (10), die den Laststrom bzw. den Leistungsverbrauch durch die Last erfaßt, der der Speisespannung entspricht, und ein zweites Signal erzeugt, das den erfaßten Strom bzw. Leistungsverbrauch anzeigt; und
eine Einrichtung (1, 3), die anzeigt, daß es zu unbefugtem Eingriff in die Vorrichtung gekommen ist,
**dadurch gekennzeichnet,** daß in die Einrichtung (1, 3) das erste und das zweite Signal als erster bzw. zweiter Eingang eingegeben werden, und sie anzeigt, daß es zu unbefugtem Eingriff in die Vorrichtung gekommen ist, wenn der zweite Eingang das Vorhandensein von Laststrom bzw. Leistungsverbrauch anzeigt, während der erste Eingang das Fehlen einer entsprechenden Speisespannung anzeigt.

2. Vorrichtung nach Anspruch 1, wobei der erste Eingang als das Fehlen einer entsprechenden Spannung anzeigend interpretiert wird, wenn er anzeigt, daß die Spannung auf Null fällt.

3. Vorrichtung nach Anspruch 1, wobei der erste Eingang als das Fehlen einer entsprechenden Spannung anzeigend interpretiert wird, wenn er anzeigt, daß die Spannung unter eine vorgegebene Schwelle fällt.

4. Vorrichtung nach Anspruch 1, 2 oder 3, die des weiteren eine Einrichtung umfaßt, die eine Eingriffsmarkierung in einer Speichereinrichtung (3) setzt, wenn unbefugter Eingriff angezeigt wird.

5. Vorrichtung nach Anspruch 4, wobei die Anzeige unbefugten Eingriffs über wenigstens einen vorgegebenen Zeitraum vorhanden sein muß, damit die Eingriffsmarkierunq gesetzt wird.

6. Vorrichtung nach Anspruch 4 oder 5, die des weiteren eine Einrichtung umfaßt, die in der Speichereinrichtung (3) Informationen bezüglich des Datums und des Zeitpunktes unbefugten Eingriffs speichert.

7. Vorrichtung nach einem der vorangehenden Ansprüche zum Überwachen einer mehrphasigen Elektrizitätsversorgung, die die erste und die zweite Einrichtung (10,12) für jede einer Vielzahl von Phasen umfaßt, sowie eine Einrichtung, die unbefugten Eingriff in eine beliebige der Versorgungsphasen anzeigt.

8. Vorrichtung nach Anspruch 7, die eine Einrichtung umfaßt, die aufzeichnet, in welcher Phase bzw. welchen Phasen es zu unbefugtem Eingriff gekommen ist.

9. Vorrichtung nach Anspruch 7 oder 8, die des weiteren eine Einrichtung umfaßt, die auf das erste und das zweite Signal anspricht und die durch die Last von der Versorgung verbrauchte Energie errechnet.

10. Vorrichtung nach Anspruch 9, die des weiteren eine Einrichtung umfaßt, die die Energiemenge schätzt, die verbraucht, jedoch aufgrund unbefugten Eingriffs nicht gemessen wurde.

11. Vorrichtung nach Anspruch 10, wobei die Energieschätzung davon ausgeht, daß die in jeder Phase, in der unbefugter Eingriff angezeigt wird, verbrauchte Energiemenge dem Durchschnitt der in der Phase bzw. den Phasen, in denen kein unbefugter Eingriff angezeigt wird, verbrauchten Energie entspricht.

12. Vorrichtung nach Anspruch 11, die sich zum Einsatz in mehrphasigen Kreisen eignet, bei denen die Anzahl eingesetzter Drähte der der Phasen entspricht, wobei die Energie unter Verwendung des tatsächlichen Stroms geschätzt wird, der in jeder Phase fließt, in der unbefugter Eingriff angezeigt wird, und die Korrektur für die Phasenverschiebung mittels einer Verweistabelle ausgeführt wird.

13. Vorrichtung nach Anspruch 10, wobei die Energieschätzung davon ausgeht, daß die Spannung, die in jeder Phase vorhanden ist, in der unbefugter Eingriff angezeigt wird, die gleiche ist, wie die Durchschnittsspannung in der Phase bzw. den Phasen, in denen kein unbefugter Eingriff angezeigt wird, und der tatsächliche Strom genutzt wird, der in jeder Phase fließt, in der unbefugter Eingriff angezeigt wird.

14. Verfahren zum Nachweisen unbefugten Eingriffs in eine Vorrichtung zum Überwachen einer Elektrizitätsversorgung einer Last, das umfaßt:
Erfassen der Speisespannung und Erzeugen eines ersten Signals, das die erfaßte Spannung anzeigt;
Erfassen des Laststroms bzw. des Leistungsverbrauchs durch die Last, der der Speisespannung entspricht, und Erzeugen eines zweiten Signals, das den zweiten Strom bzw. den Leistungsverbrauch anzeigt; und
Anzeigen, daß es zu unbefugtem Eingriff in die Vorrichtung gekommen ist,
**dadurch gekennzeichnet,** daß das Verfahren das Überwachen des ersten und des zweiten Signals und des Anzeigens des Auftretens von unbefugtem Eingriff umfaßt, wenn das zweite Signal das Vorhandensein von Laststrom bzw. Leistungsverbrauch anzeigt, während das erste Signal das Fehlen einer entsprechenden Speisespannung anzeigt.

15. Verfahren nach Anspruch 14, wobei das erste Signal als das Fehlen einer entsprechenden Spannung anzeigend interpretiert wird, wenn es anzeigt, daß die Spannung auf Null fällt.

16. Verfahren nach Anspruch 14, wobei das erste Signal als das Fehlen einer entsprechenden Spannung anzeigend interpretiert wird, wenn es anzeigt, daß die Spannung unter eine vorgegebene Schwelle fällt.

17. Verfahren nach Anspruch 14, 15 oder 16, das des weiteren das Setzen einer Eingriffsmarkierung in einer Speichereinrichtung (3) umfaßt, wenn unbefugter Eingriff angezeigt wird.

18. Verfahren nach Anspruch 17, wobei die Anzeige unbefugten Eingriffs wenigstens über einen vorgegebenen Zeitraum vorhanden sein muß, damit die Eingriffsmarkierung gesetzt wird.

19. Verfahren nach Anspruch 17 oder 18, das des weiteren das Speichern von Informationen bezüglich des Datums und des Zeitpunktes unbefugten Eingriffs in der Speichereinrichtung umfaßt.

20. Verfahren nach einem der Ansprüche 14-19 zum Nachweisen unbefugten Eingriffs in eine Vorrichtung zum Überwachen einer mehrphasigen Elektrizitätsversorgung einer Last, wobei das Verfahren das Anzeigen unbefugten Eingriffs in eine beliebige der Versorgungsphasen umfaßt.

21. Verfahren nach Anspruch 20, das das Aufzeichnen der Phase bzw. Phasen umfaßt, in der bzw. denen es zu unbefugtem Eingriff gekommen ist.

22. Verfahren nach Anspruch 20 oder 21, das des weiteren das Errechnen der durch die Last von der Versorgung verbrauchten Energie als eine Funktion des ersten und des zweiten Signals umfaßt.

23. Verfahren nach Anspruch 22, das des weiteren das Schätzen des Betrages der verbrauchten, jedoch aufgrund unbefugten Eingriffs nicht gemessenen Energiemenge umfaßt.

24. Verfahren nach Anspruch 23, wobei die Energieschätzung davon ausgeht, daß die in jeder Phase, in der unbefugter Eingriff angezeigt wird, verbrauchte Energiemenge dem Durchschnitt der in der Phase bzw. den Phasen, in denen kein unbefugter Eingriff angezeigt wird, verbrauchten Energie entspricht.

25. Verfahren nach Anspruch 24, wobei die Energie unter Verwendung des tatsächlichen Stroms geschätzt wird, der in jeder Phase fließt, in der unbefugter Eingriff angezeigt wird, und das des weiteren die Korrektur für die Phasenverschiebung mittels einer Verweistabelle umfaßt.

26. Verfahren nach Anspruch 23, wobei die Energieschätzung davon ausgeht, daß die Spannung, die in jeder Phase vorhanden ist, in der unbefugter Eingriff angezeigt wird, die gleiche ist, wie die Durchschnittsspannung in der Phase bzw. den Phasen, in denen kein unbefugter Eingriff angezeigt wird, und der tatsächliche Strom in jeder Phase genutzt wird, in der unbefugter Eingriff angezeigt wird.

## Revendications

1. Appareil destiné à contrôler la fourniture d'électricité à une charge, comprenant :
un premier moyen de détection (12) servant à détecter la tension d'alimentation et à produire un premier signal indicatif de la tension détectée ;
un deuxième moyen de détection (10) servant à détecter le courant de charge ou la consommation de puissance par la charge correspondant à la tension d'alimentation et à produire un deuxième signal indicatif du courant détecté ou de la consommation de puissance détectée ; et
un moyen (1,3) qui indique qu'une manipulation frauduleuse s'est produite dans l'appareil,
caractérisé en ce que ledit moyen (1, 3) est conçu de façon que lui soient respectivement appliqués, comme premier et deuxième signaux d'entrée, lesdits premier et deuxième signaux et en ce qu'il indique qu'une manipulation frauduleuse s'est produite dans l'appareil lorsque le deuxième signal d'entrée indique la présence d'un courant de charge ou d'une consommation de puissance tandis que le premier signal d'entrée indique l'absence d'une tension d'alimentation correspondante.

2. Appareil selon la revendication 1, où le premier signal d'entrée est considéré comme indiquant l'absence d'une tension correspondante s'il indique que la tension tombe à zéro.

3. Appareil selon la revendication 1, où le premier signal d'entrée est considéré comme indiquant l'absence d'une tension correspondante s'il indique que la tension tombe en deçà d'un seuil prédéterminé.

4. Appareil selon la revendication 1, 2 ou 3, comprenant en outre un moyen qui positionne un drapeau de fraude dans un moyen de mémorisation (3) lorsqu'une manipulation frauduleuse est indiquée.

5. Appareil selon la revendication 4, où l'indication de manipulation frauduleuse doit être présente pendant au moins une durée prédéterminée pour que le drapeau de fraude soit positionné.

6. Appareil selon la revendication 4 ou 5, comprenant en outre un moyen destiné à stocker dans le moyen de mémorisation (3) une information indiquant la date et l'heure de la manipulation frauduleuse.

7. Appareil selon l'une quelconque des revendications précédentes, destiné à contrôler la fourniture d'électricité polyphasée et comprenant lesdits premier et deuxième moyens (10, 12) pour chaque phase d'une pluralité de phases et un moyen servant à indiquer une manipulation frauduleuse dans l'une quelconque des phases d'alimentation.

8. Appareil selon la revendication 7, comprenant un moyen qui sert à enregistrer dans quelle phase ou quelles phases la manipulation frauduleuse a eu lieu.

9. Appareil selon la revendication 7 ou 8, comprenant en outre un moyen qui répond auxdits premier et deuxième signaux en calculant l'énergie consommée par la charge en provenance de l'alimentation.

10. Appareil selon la revendication 9, comprenant en outre un moyen qui sert à estimer la quantité d'énergie utilisée, mais non mesurée, du fait de la manipulation frauduleuse.

11. Appareil selon la revendication 10, où l'estimation de l'énergie s'appuie sur le fait que la quantité d'énergie utilisée dans chaque phase pour laquelle une manipulation frauduleuse est indiquée est la même que la moyenne de l'énergie utilisée dans la phase ou dans les phases où aucune manipulation frauduleuse n'est indiquée.

12. Appareil selon la revendication 11, qui est destiné à être utilisé dans des circuits polyphasés employant le même nombre de fils qu'il y a de phases et où on estime l'énergie à l'aide du courant réel circulant dans chaque phase où une manipulation frauduleuse est indiquée et en corrigeant l'effet du déphasage au moyen d'une table de recherche.

13. Appareil selon la revendication 10, où on estime l'énergie en supposant que la tension présente dans chaque phase où une manipulation frauduleuse est indiquée est la même que la tension moyenne dans la phase ou les phases où aucune manipulation frauduleuse n'est indiquée et en utilisant le courant réel qui circule dans chaque phase où une manipulation frauduleuse est indiquée.

14. Procédé permettant de détecter une manipulation frauduleuse dans un appareil destiné à contrôler la fourniture d'électricité à une charge, comprenant les opérations suivantes :
détecter la tension d'alimentation et produire un premier signal indicatif de la tension détectée ;
détecter le courant de charge ou la consommation de puissance par la charge correspondant à la tension de charge et produire un deuxième signal indicatif du courant détecté ou de la consommation de puissance détectée ; et
indiquer qu'une manipulation frauduleuse s'est produite dans l'appareil,
caractérisé en ce que ledit procédé comprend les opérations consistant à contrôler lesdits premier et deuxième signaux et à indiquer qu'une manipulation frauduleuse a eu lieu lorsque le deuxième signal indique la présence d'un courant de charge ou d'une consommation de puissance tandis que le premier signal indique l'absence d'une tension d'alimentation correspondante.

15. Procédé selon la revendication 14, où on considère le premier signal comme indiquant l'absence d'une tension correspondante s'il indique que la tension tombe à zéro.

16. Procédé selon la revendication 14, où on considère le premier signal comme indiquant l'absence d'une tension correspondante s'il indique que la tension tombe en deçà d'un seuil prédéterminé.

17. Procédé selon la revendication 14, 15 ou 16, comprenant en outre l'opération consistant à positionner un drapeau de fraude dans un moyen de mémorisation (3) lorsqu'une manipulation frauduleuse est indiquée.

18. Procédé selon la revendication 17, où l'indication de manipulation frauduleuse doit être présente pendant au moins une durée prédéterminée pour que le drapeau de fraude soit positionné.

19. Procédé selon la revendication 17 ou 18, comprenant en outre l'opération qui consiste à stocker dans le moyen de mémorisation une information concernant la date et l'heure de la manipulation frauduleuse.

20. Procédé selon l'une quelconque des revendications 14 à 19, permettant de détecter une manipulation frauduleuse dans un appareil destiné à contrôler la fourniture d'électricité polyphasée à une charge, le procédé comprenant l'opération qui consiste à indiquer une manipulation frauduleuse dans l'une quelconque des phases d'alimentation.

21. Procédé selon la revendication 20, comprenant l'opération qui consiste à enregistrer dans quelle phase ou quelles phases la manipulation frauduleuse a eu lieu.

22. Procédé selon la revendication 20 ou 21, comprenant en outre l'opération qui consiste à calculer l'énergie consommée par la charge, en provenance de l'alimentation, sous la forme d'une fonction desdits premier et deuxième signaux.

23. Procédé selon la revendication 22, comprenant en outre l'opération qui consiste à estimer la quantité d'énergie utilisée, mais non mesurée, du fait de la manipulation frauduleuse.

24. Procédé selon la revendication 23, où on estime l'énergie en supposant que la quantité d'énergie utilisée dans chaque phase où une manipulation frauduleuse est indiquée est la même que la moyenne de l'énergie utilisée dans la phase ou les phases où une manipulation frauduleuse n'est pas indiquée.

25. Procédé selon la revendication 24, où on estime l'énergie en utilisant le courant réel qui circule dans chaque phase où une manipulation frauduleuse est indiquée, et comprenant en outre l'opération qui consiste à corriger l'effet du déphasage au moyen d'une table de recherche.

26. Procédé selon la revendication 23, où on estime l'énergie en supposant que la tension présente dans chaque phase où une manipulation frauduleuse est indiquée est la même que la tension moyenne dans la phase ou les phases où une manipulation frauduleuse n'est pas indiquée et en utilisant le courant réel dans chaque phase où une manipulation frauduleuse est indiquée.
